## Europäisches Patentamt
## European Patent Office
## Office européen des brevets

(11) Publication number: **0 079 446**
**B1**

# EUROPEAN PATENT SPECIFICATION

(45) Date of publication of patent specification: **10.07.85**

(51) Int. Cl.⁴: **H 03 L 7/10**

(21) Application number: **82108768.1**

(22) Date of filing: **22.09.82**

(54) **Phase-locked circuits.**

(30) Priority: **16.11.81 US 321508**

(43) Date of publication of application:
**25.05.83 Bulletin 83/21**

(45) Publication of the grant of the patent:
**10.07.85 Bulletin 85/28**

(84) Designated Contracting States:
**DE FR GB**

(56) References cited:
**GB-A-2 089 602**
**US-A-3 904 988**
**US-A-4 007 429**

**IBM TECHNICAL DISCLOSURE BULLETIN, vol. 13, no. 8, January 1971 ARMONK, New York pages 2170, 2171**

(73) Proprietor: **International Business Machines Corporation**
**Old Orchard Road**
**Armonk, N.Y. 10504 (US)**

(72) Inventor: **Call, Mark Gregory**
**4297 Redwood Court**
**Boulder Colorado 80301 (US)**

(74) Representative: **Lewis, Alan John**
**IBM United Kingdom Patent Operations Hursley Park**
**Winchester, Hants, S021 2JN (GB)**

Courier Press, Leamington Spa, England.

## Description

The present invention relates to phase-lock loop circuits (PLL) comprising controlled oscillators.

The use of phase-lock loops (PLLs) in electromechanical control, data acquisition, etc is well known in the prior art. A typical PLL consists of a phase detector, a low pass filter and a voltage-controlled oscillator (VCO). The enumerated elements are usually coupled to form a closed-loop system. The phase detector measures small differences in phase between an incoming signal and a feedback signal from the VCO. Any detected differences generate an error signal which is filtered and is supplied to the VCO. The VCO manipulates the error signal so as to minimize the frequency difference between the feedback signal and the incoming signal.

A good many applications require that the PLL have a tight frequency control, short acquisition or lock time and relatively wide lock frequency range. Unfortunately, these requirements are mutually exclusive. Therefore, a design which tends to achieve one of the above requirements tends to adversely affect the others.

U.S. Patent 4,007,429 describes a phaselocked loop with a switched low-pass filter. The switched low-pass filter has two different bandwidths. One of the bandwidths has a wide frequency response for use during acquisition period. The other bandwidth has a relatively narrow frequency response and is used during normal tracking for tight control of the voltage-controlled oscillator. A loss of lock detector controls the particular filter bandwidth state by causing certain filter components to be switched in and out according to the presence or absence of phase-lock condition.

Accordingly, it is a broad object of the present invention to provide a PLL which is more efficient than has heretofore been possible.

More particularly, it is the object of the present invention to provide a PLL which has a relatively wide lock frequency range, a relatively short acquisition time and tight frequency control during the period when the loop is locked.

The above and other objects of the present invention are achieved in the embodiment of the invention described hereinafter by two electrical circuits which are coupled in the PLL and independently adjust the gain (Kv) and the free run or centre frequency of the VCO. The PLL includes a phase detector, a loop filter, an amplifier and a VCO. The VCO includes a current-controlled oscillator (ICO) connected in series to the two electrical circuits. The electrical circuits are coupled in a summing difference configuration. The current which is generated from the summing difference configuration drives the ICO. Independent current mirrors are utilized to deliver the current from the independent circuits into the common node of the summing difference configuration.

The invention provides, a phase-locked loop circuit including an oscillator capable of producing an output signal ($F_o$, $F_{out}$) with a frequency and loop gain determined by a control signal supplied thereto; a phase comparator means operable to compare the output signal with an input signal ($F_{in}$) and to provide an error signal representative of any difference in phase therebetween; and circuitry receiving the error signal for generation the control signal, said loop circuit being characterised in that the control-signal-circuitry comprises first and second circuit means capable of supplying first and second currents ($I_{fr}$, $I_{gain}$) to a summing node connected to the control signal input terminal of the oscillator, said first circuit means having a control terminal at which an externally settable voltage or current is applied and the setting of which determines the magnitude of the first current ($I_{fr}$) and said second circuit means having a control terminal at which the error signal is applied, which signal determines the magnitude of the second current ($I_{gain}$) whereby, in the absence of an error signal, the output of the oscillator is determined by the setting of the applied voltage or current, and in the presence of an error signal, the output of the oscillator is determined by both the setting of the applied voltage or current and the error signal.

In a feature of the invention, the PLL is fabricated in a module or chip utilizing integrated circuit technology. The two circuit controllers are generated from nonintegrated circuit technology and are disposed off the chip. By having nonintegrated circuit controllers off the chip, the PLL is transformed into a universal chip which may be used for different applications, etc.

The invention will now be further described with reference to the accompanying drawings, in which:—

Figure 1 shows a schematic of a prior art PLL.

Figure 2 shows a block diagram of a PLL in accordance with the present invention.

Figure 3 shows a circuit diagram showing part of the electrical circuitry of the oscillator. The diagram is helpful in showing the utilization of the invention in manufacturing a partially integrated PLL chip.

The present invention provides an improved phase-lock loop having a voltage-controlled oscillator (VCO) therein. The VCO includes a current-controlled oscillator (ICO) coupled in series to an input controller. The input controller comprises of a circuit means which is coupled in a summing difference configuration and generates current which sets the gain and/or free-run frequency ($F_{fr}$) of the ICO. The circuits operate so that the setting of the VCO gain ($K_v$) and the free-run frequency are mutually independent.

The phase-lock loop, provided by the present invention, is a universal loop in that a single loop can be used for matching a plurality of different frequencies. To this end, the component of the phase-lock loop including the ICO can be fabricated on a chip using integrated circuit technology while the input controller to the ICO is generated off the chip. This universal characteristic of the described phase-lock loop presents a different feature to a user which was not present in the prior art.

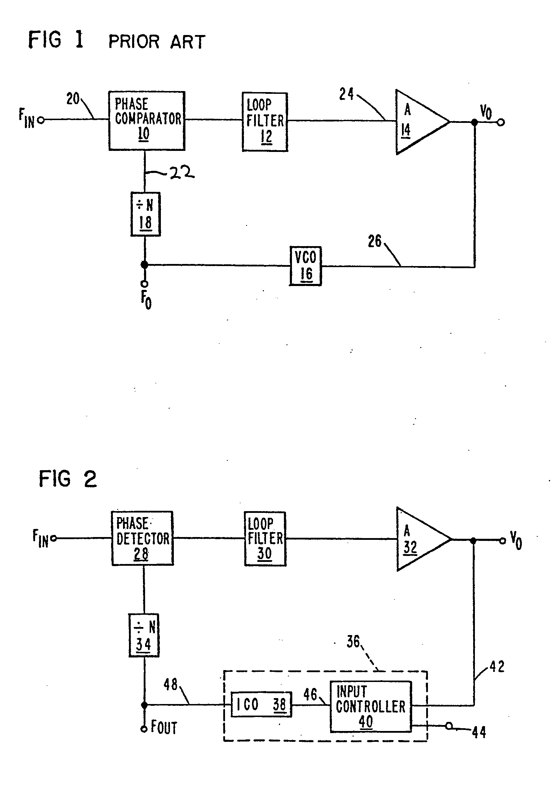

Figure 1 shows a prior art phase-locked loop. The loop consists of the conventional loop components: phase comparator 10, loop filter 12, amplifier 14, VCO 16 and a divided by N circuit 18. The input signal $F_{in}$ is applied on conductor 20 to the phase comparator 10. The phase comparator 10 generates an error signal which is proportional to the difference in phase between the input signal on conductor 20 and the phase of the output signal fed back to the comparator on conductor 22. This error signal is then applied to loop filter 12. The unwanted frequency is filtered out of the signal and the signal is fed over conductor 24 into amplifier 14. The signal is amplified in amplifier 14 and is fed over conductor 26 to VCO 16. The signal on conductor 26 is a voltage signal and is identified as $V_o$. The VCO is a conventional device which accepts a voltage signal and outputs a signal whose frequency is proportional to the input voltage signal. The signal $F_o$ which is outputted from VCO 16 is supplied to an optional divide circuit 18. The function of the divide by N circuit 18 is to reduce the frequency of the signal outputted by the VCO. This frequency is compared with the input signal $F_{in}$. If the signals are out of phase, an error signal is generated by the phase comparator. A more detailed description of a PLL is given in the above-described U.S. Patent 4,007,429. It should be noted that when the phase of the signal on conductors 20 and 22 are identical, the VCO is operating at its free-run centre or midpoint frequency.

It should be noted that the loop gain for the PLL may be expressed by the following expression:

$$Loop \ gain = AK_pKcK_v$$

where:
  A represents the gain of the amplifier
  $K_p$ represents the gain of the phase detector
  $K_c$ represents the gain of the loop filter
  $K_v$ represents the gain of the VCO.

It has been observed that closed-loop PLL performance is highly dependent on the loop gain. To this end, once a PLL has been designed to match a particular use, any attempt to use the loop for another purpose was very difficult. This is so because any attempt to change any of the components in the loop would affect the gain and, as such, modify the loop characteristics. Other PLL performances which are affected by loop gain are: time-to-lock, lock range, lock acquisition range and bandwidth. Since all of these functions depend on loop gain, any attempt to utilize a PLL for a use other than that for which it was designed requires significant redesign, due to the engineering tradeoffs required for optimization of the prior art PLL. This process made circuit integration of significant portions of the PLL difficult for many applications and resulted in long redesign and fabrication leadtimes.

We have determined that by controlling the VCO so that the gain ($K_v$) and the free-run frequency ($F_{fr}$) can be adjusted independently, a single phase-locked loop could be utilized for various applications. Moreover, by independently adjusting the free-run frequency and the gain of the VCO, preferably by circuits external to the loop, the overall gain of the loop can be maintained constant and, as such, does not affect the overall performance of a loop. This determination is the basis for the present invention. Also, this determination made it more practical for the loop to be manufactured from integrated circuit technology.

Figure 2 shows an improved phase-locked loop according to the present invention. The conventional elements of the loop are phase detector 28, loop filter 30, amplifier 32 and divide circuit 34. The functions of these elements are substantially the same as the previously described conventional loop elements and, as such, will not be described here. Besides the conventional components of the phase-locked loop are also the improved VCO identified by numeral 36. The VCO 36 includes a current-controlled oscillator 38 (ICO) and an input controller 40. The input controller 40 is characterised by two inputs. One of the inputs is the feedback error voltage signal on conductor 42 and the other input is on conductor 44 and is coupled to a reference signal. The output from input controller 40 is fed over conductor 46 to control the ICO.

The output from ICO 38 is fed over conductor 48 into the divide circuit 34. The output signal from input controller 40 independently sets the gain ($K_v$) and/or the free-run frequency of the ICO. It should be noted that the electrical circuits of the ICO can be the same as the electrical circuits of a conventional VCO e.g. by generating a control voltage in accordance with the control current. By way of example, U.S. Patent 3,904,988 describes a VCO which derives a control current from the input voltage signal and could be used herein. Also, *IBM Technical Disclosure Bulletin* Vol. 13, No. 8, January 1971 (page 2170) discloses an article which describes a voltage-controlled oscillator having two control inputs and which could be used in the present invention. Since these known VCO's can be used in the circuit described hereih, no specific description or details of the ICO will be given. However, whereas in the conventional loop the error signal is fed directly into the VCO, in the improved loop according to the present invention, the error voltage is processed prior to its application to the ICO.

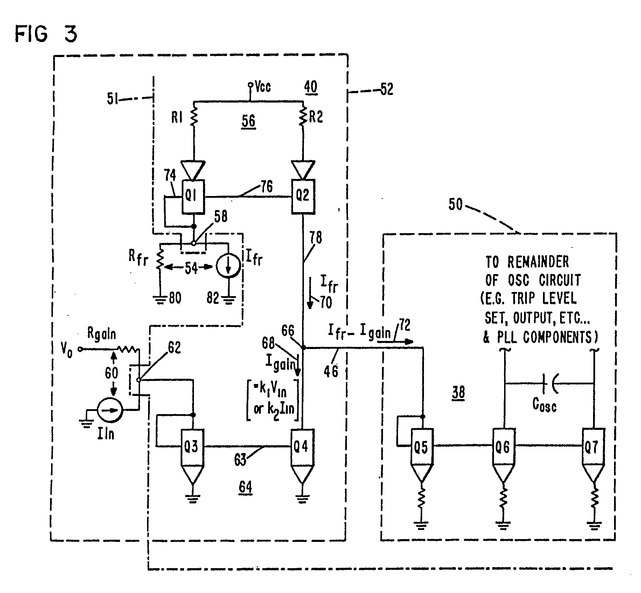

Referring now to Figure 3, a schematic of the electrical circuit which forms the improved VCO is shown. The portion of the schematic which is enclosed by the block 50, represents a partial showing of the ICO. The elements enclosed by block 52 identify the electrical components of input controller 40 (Figure 2). As was stated previously, the partial ICO shown in block 50 includes electrical circuits substantially identical to a conventional VCO. However, in the conventional VCO, a voltage signal is fed into the VCO. With the ICO of the present invention, a current is fed into the components. Since the components of the ICO are substantially identical to those of the VCO, details of the complete ICO circuit are not shown in the figure. Suffice it to say that the oscillatory capacitor ($C_{osc}$) is driven by current mirrors Q5 and Q6, respectively. As such, the current which is generated by input controller 40 is fed over conductor 46 into the ICO 38. Of course, only a portion of the electrical elements of ICO 38 is shown in Figure 3. It should be understood that the balance of the circuit is substantially the same as a conventional VCO.

Still referring to Figure 3, the input controller 40 includes an external circuit means 54 which is connected at node 58 to a current mirror 56. The current $I_{fr}$ which is outputted from current mirror 56 is set by the external circuit means 54. This current $I_{fr}$ is utilized to set the free-run frequency of the ICO.

Similarly, a second external circuit means 60 is connected at node 62 to current mirror 64. The current $I_{gain}$ which is outputted from the current mirror 64 is a function of the desired gain ($K_v$) of the ICO. The components 54, 56, 60 and 64 are coupled in a summing difference configuration at node 66. With this configuration, the current $I_{gain}$ flows in the direction shown by arrow 68 while the current $I_F$ flows in the direction identified by arrow 70. As such, the current which is generated on conductor 46 flows in the direction shown by arrow 72 and is equivalent to $(I_{fr}-I_{gain})$.

The external circuit means 54 comprises of either a resistor $R_{fr}$ coupled at one end to a ground or reference potential and at the other end to node 58, or a current source $I_{fr}$ coupled to node 58 with current flowing in the direction shown by the arrow. The current mirror 56 includes a pair of PNP transistors Q1 and Q2, respectively. The base of transistor Q1 is coupled by conductor 74 to the collector of the same transistor. As such, transistor Q1 is functioning as a diode. The emitter of transistor Q1 is connected through R1 to supply voltage $V_{cc}$. The base of transistor Q1 is coupled by conductor 76 to the base on transistor Q2. The emitter of transistor Q2 is tied through resistor R2 to supply voltage $V_{cc}$. The collector of transistor Q2 is tied to node 66 by conductor 78. It should be noted that conductor 44 (Figure 2) is identical to conductor 80 or 82 (Figure 3). If the input or external circuit 54 is represented by the resistor $R_{fr}$, conductor 80 (Figure 3) and conductor 44 (Figure 2) are identical. Similarly, if the current source $I_{fr}$ is utilized as an external circuit means 54, conductor 82 is identical to conductor 44.

Still referring to Figure 3, the external circuit 60 comprises of an external resistor $R_{gain}$ or a current source $I_{in}$. In operation either one, but not both, is coupled to terminal 62. It should be noted that the signal $V_o$ which is supplied to $R_{gain}$ is identical to the signal $V_o$ in Figure 2. The current which is generated at node 62 is coupled into the summing difference node 66 by current mirror 64. The current mirror 64 includes a pair of NPN transistors Q3 and Q4, respectively. The base of transistors Q3 and Q4 are coupled by conductor 63. The emitter of both transistors are tied to ground or some reference potential. The collector and emitter of Q3 is connected so that the transistor operates as a diode. As can be seen from the configuration, the current $I_{gain}$ which flows in the direction shown by arrow 68 is equivalent to $K_1 V_{IN}$ or $K_2 I_{in}$ (with K being a constant in the expression). It is worthwhile noting that when $V_o$ (that is the instantaneous error signal) is at its median voltage, the VCO oscillates at its free-run frequency, $F_{fr}$. As was stated previously, one attribute of the present invention is that it allows a single PLL to be utilized universally (that is for more than one set of frequencies). In such a configuration, a plurality of $R_{fr}$ or $I_{fr}$ are coupled to node 58.

Also, the PLL, according to the invention, is more adaptable for fabrication using integration technology. To this end, a portion of the PLL including the current mirrors 56, 64 and the other elements of the loop blocked off by lines 51 and including the phase detector, loop filter, ICO, amplifier and the divide circuit are fabricated on a chip. The input terminal into the chip would be node 58 and 62 respectively. The external circuits 54 and 60 need not be the integrated section of the module. By attaching several different resistors or $I_{fr}$ current source at node 58, the module could be adapted for several different uses.

The improved PLL, according to the teaching of the present invention, can allow a user fast lock time, wider frequency response, and narrow filter bandwidth by means of multiple mode operation.

Hereinbefore there has been described an improved phase-lock loop (PLL) module comprising a support substrate; input terminal means operably mounted on the substrate; an integrated section to said module operably disposed on the substrate with the integrated section being in electrical communication with the terminal; a nonintegrated section disposed in electrical communication with the terminal, said integrated section including a phase comparator; a loop filter connected to the phase comparator; a current-controlled oscillator having its output coupled to the phase comparator; a first current mirror means; a second current mirror means; said first and second current mirror means coupled in a summing difference configuration and operable to generate a controlled signal to drive the ICO; and said nonintegrated section including a pair of electrical circuits, one of each being coupled to the input terminal and operable respectively to set the gain $K_v$ and the centre frequency of the VCO.

## Claims

1. A phase-locked loop circuit including an oscillator (16, 38) capable of producing an output signal ($F_o$, $F_{out}$) with a frequency and loop gain determined by a control signal supplied thereto; a phase comparator means (10, 28) operable to compare the output signal with an input signal ($F_{in}$) and to provide an error signal representative of any difference in phase therebetween; and circuitry (12, 14: 30, 32, 40) receiving the error signal for generation the control signal, said loop circuit being characterised in that the control-signal-circuitry (30, 32, 40) comprises first and second circuit means (56, 64) capable of supplying first and second currents ($I_{fr}$, $I_{gain}$) to a summing node (66) connected to the control signal input terminal of the oscillator (38), said first circuit means (56) having a control terminal (58) at which an externally settable voltage or current is applied and the setting of which determines the magnitude of the first current ($I_{fr}$) and said second circuit means (64) having a control terminal (62) at which the error signal is applied, which signal determines the magnitude of the second current ($I_{gain}$) whereby, in the absence of an error signal, the output of the oscillator is determined by the setting of the applied voltage or current, and in the presence of an error signal, the output of the oscillator is determined by both the setting of the applied voltage or current and the error signal.

2. A circuit as claimed in claim 1 further characterised in that an externally settable current ($I_{in}$) can be supplied to the control terminal (62) of the second circuit means (64) whereby, in the absence of an applied error signal, the gain of the circuit can be determined independently of the frequency, by the setting of the current ($I_{in}$) applied to the second circuit means.

3. A circuit as claimed in claim 1 or 2, in which the control-signal-circuitry comprises filtering means (30) having a single characteristic bandwidth representative of the locked frequency of the loop.

4. A circuit as claimed in claim 1, 2 or 3 wherein the second circuit means (64) includes a resistor ($R_{gain}$) having a value operable, in the presence of an error signal, to set the gain of the VCO and a current mirror circuit means (Q3, Q4) coupled to said resistor ($R_{gain}$).

5. A circuit as claimed in claim 4, wherein the error signal is connected to the resistor ($R_{gain}$).

6. A circuit as claimed in claim 1, 2 or 3 wherein the second circuit means (64) includes a current source ($I_{in}$) operable, in the absence of an error signal, to set the gain of the VCO; and a current mirror circuit means (Q3, Q4) coupled to said current source.

7. A circuit as claimed in claim 4, 5 or 6, wherein the current mirror circuit means includes a pair of PNP transistors (Q3, Q4) having their bases connected together, with one of said transistors (Q3) being connected to have operating characteristics substantially equivalent to a diode.

8. A circuit as claimed in any one of claims 1 to 7, wherein the first circuit means (56) includes a supply voltage source ($V_{cc}$); a current mirror circuit means (Q1, Q2) coupled to said voltage source; and a resistor ($R_{fr}$) coupled to the current mirror circuit means.

9. A phase-locked loop circuit as claimed in claim 8, wherein the resistor ($R_{fr}$) is operable to set the free-run frequency ($F_{fr}$) of the VCO.

10. A phase-locked loop circuit as claimed in claim 8 or 9, further including resistive means (R1, R2) connecting the current mirror to the supply voltage source.

11. A phase-locked loop circuit as claimed in any one of claims 1 to 7, wherein the first circuit means (56) includes a supply voltage source ($V_{cc}$); a current source ($I_{fr}$) operable to set the free-run frequency of the VCO; and a current mirror (Q1, Q2) operable to couple the current source to the voltage supply source.

12. A circuit as claimed in any one of claims 1 to 11, further characterised in that the oscillator (38) and the comparator circuit (28) are integrated on a semi-conductor chip or substrate and in that the first and second circuit means (56, 64) comprising elements (Q1, 2, 3, 4: R1, R2) are formed on the chip or substrate and the other elements ($R_{gain}$, $R_{fr}$) are formed off the chip or substrate.

## Patentansprüche

1. PLL-Schaltung mit einem Oszillator (16, 38), welcher ein Ausgangssignal ($F_o$, $F_{out}$) mit einer Frequenz und Schleifenverstärkung, die durch ein ihm zugeführtes Steuersignal bestimmt sind, erzeugen kann, Phasenvergleichermitteln (10, 28), welche aus Ausgangssignal mit einem Eingangssignal ($F_{in}$) vergleichend und ein eine Phasendifferenz zwischen diesen darstellendes Fehlersignal liefernd betreibbar sind, und einem Schaltungsaufbau (12, 14: 30, 32, 40), welcher das Fehlersignal zur Erzeugung des Steuersignals erhält, dadurch gekennzeichnet, daß der Steuersignalschaltungsaufbau (30, 32, 40) erste und zweite Schaltungsmittel (56, 64) umfaßt, welche einem mit dem Steuersignaleingang des Oszillators (38) verbundenen Summierungsknoten (66) einen ersten und einen zweiten Strom ($I_{fr}$, $I_{gain}$) zuführen können, wobei die ersten Schaltungsmittel (56) einen Steueranschluß (58) aufweisen, auf welchen eine von außen einstellbare Spannung oder ein von außen einstellbarer Strom gegeben wird, deren bzw. dessen Einstellung die Größe des ersten Stroms ($I_{fr}$) bestimmt, und die zweiten Schaltungsmittel (64) einen Steuereingang (62) aufweisen, auf welchen das Fehlersignal gegeben wird, das die Größe des zweiten Stroms ($I_{gain}$) bestimmt, wodurch die Ausgabe des Oszillators bei Fehlen eines Fehlersignals durch die Einstellung der aufgegebenen Spannung bzw. des aufgegebenen Stroms und bei Vorhandensein eines Fehlersignals sowohl durch die Einstellung der aufgegebenen Spannung bzw. des aufgegebenen Stromes als auch durch das Fehlersignal bestimmt wird.

2. Schaltung nach Anspruch 1, ferner dadurch gekennzeichnet, daß ein von außen einstellbarer Strom ($I_{in}$) dem Steuereingang (62) der zweiten Schaltungsmittel (64) zugeführt werden kann, wodurch bei Fehlen eines aufgegebenen Fehlersignals die Verstärkung der Schaltung unabhängig von der Frequenz durch die Einstellung des auf die zweiten Schaltungsmittel gegebenen Stroms ($I_{in}$) bestimmt werden kann.

3. Schaltung nach Anspruch 1 oder 2, bei welcher der Steuersignalschaltungsaufbau Filtermittel (30) mit einer einzigen charakteristischen Bandbreite, welche die verriegelte Frequenz der Schleife darstellt, aufweist.

4. Schaltung nach Anspruch 1, 2 oder 3, bei welcher die zweiten Schaltungsmittel (64) einen Widerstand ($R_{gain}$) mit einem Wert, welcher, bei Vorhandensein eines Fehlersignals, die Verstärkung des spannungsgesteuerten Oszillators einstellend ist, und mit dem Widerstand ($R_{gain}$) gekoppelte Stromspiegelschaltungsmittel (Q3, Q4) enthalten.

5. Schaltung nach Anspruch 4, bei welcher das Fehlersignal mit dem Widerstand ($R_{gain}$) verbunden ist.

6. Schaltung nach Anspruch 1, 2 oder 3, bei welcher die zweiten Schaltungsmittel (64) eine Stromquelle ($I_{in}$), welche, bei Fehlen eines Fehlersignals, die Verstärkung des spannungsgesteuerten Oszillators einstellt, und mit der Stromquelle gekoppelte Stromspiegelschaltungsmittel (Q3, Q4) enthalten.

7. Schaltung nach Anspruch 4, 5 oder 6, bei welcher die Stromspiegelschaltungsmittel ein Paar von PNP-Transistoren (Q3, Q4) mit verbundenen Basen enthalten, wobei einer der Transistoren (Q3) so verschaltet ist, daß er eine Arbeitscharakteristik aufweist, die im wesentlichen der einer Diode entspricht.

8. Schaltung nach irgendeinem der Ansprüche 1 bis 7, bei welcher die ersten Schaltungsmittel (56) eine Spannungsquelle ($V_{cc}$), mit der Spannungsquelle verbundene Stromspiegelschaltungsmittel (Q1, Q2) und einen mit den Stromspiegelschaltungsmitteln verbundenen Widerstand ($R_{fr}$) enthalten.

9. PLL-Schaltung nach Anspruch 8, bei welcher der Widerstand ($R_{fr}$) die Freilauffrequenz ($F_{fr}$) des spannungsgesteuerten Oszillators einstellt.

10. PLL-Schaltung nach Anspruch 8 oder 9, welcher ferner die Stromspiegelung mit der Spannungquelle verbindende Widerstandsmittel (R1, R2) enthält.

11. PLL-Schaltung nach irgendeinem der Ansprüche 1 bis 7, bei welcher die ersten Schaltungsmittel (56) eine Spannungsquelle ($V_{cc}$), eine die Freilauffrequenz des spannungsgesteuerten Oszillators einstellende Stromquelle ($I_{fr}$) und eine die Stromquelle mit der Spannungsquelle koppelnde Stromspiegelung (Q1, Q2) enthält.

12. Schaltung nach irgendeinem der Ansprüche 1 bis 11, ferner dadurch gekennzeichnet, daß der Oszillator (38) und die Vergleicherschaltung (28) auf einem Halbleiterchip bzw. -substrat integriert sind und daß die Elemente (Q1, 2, 3, 4: R1, R2) umfassenden ersten und zweiten Schaltungsmittel (56, 64) auf dem Chip bzw. Substrat und die anderen Elemente ($R_{gain}$, $R_{fr}$) außerhalb des Chips bzw. Substrats ausgebildet sind.

## Revendications

1. Circuit en forme de boucle à verrouillage de phase comportant un oscillateur (16, 38) apte à produire un signal de sortie ($F_o$, $F_{out}$) possédant une fréquence et un gain de boucle déterminés par un signal de commande qui lui est appliqué, un comparateur de phase (10, 28) apte à comparer le signal de sortie à un signal d'entrée ($F_{in}$) et à fournir un signal d'erreur représentatif de toute différence de phase entre ces signaux, et un montage (12, 14; 30, 32, 40) recevant le signal d'erreur en vue de produire le signal de commande, ledit circuit en forme de boucle étant caractérisé en ce que le montage (30, 32, 40) délivrant les signaux de commande comporte un premier et un second circuits (56, 64) aptes à délivrer un premier et un second courants ($I_{fr}$, $I_{gain}$) à un noeud de sommation (66) raccordé à la borne d'entrée du signal de commande de l'oscilloscope (38), ledit premier circuit (56) comportant une borne de commande (58) à laquelle une tension ou un courant pouvant être réglé de l'extérieur est appliqué et dont le réglage détermine l'intensité du premier courant ($I_{fr}$), et ledit second circuit (64) comportant une borne de commande (62), à laquelle le signal d'erreur est appliqué, lequel signal détermine l'intensité du second courant ($I_{gain}$), ce qui a pour effet que, en l'absence d'un signal d'erreur, la sortie de l'oscillateur est déterminée par le réglage de la tension ou du courant appliqué, et dans le cas de la présence d'un signal d'erreur, la sortie de l'oscillateur est déterminée à la fois par le réglage de la tension ou du courant appliqué et par le signal d'erreur.

2. Circuit selon la revendication 1, caractérisé en outre en ce qu'un courant ($I_{in}$) réglable de l'extérieur peut être envoyé à la borne de commande (62) du second circuit (64), ce qui a pour effet que, dans le cas de l'absence d'un signal d'erreur appliqué, le gain du circuit peut être déterminé d'une manière indépendante de la fréquence, par réglage du courant ($I_{in}$) appliqué au second circuit.

3. Circuit selon la revendication 1 ou 2, dans lequel le montage délivrant les signaux de commande comporte des moyens de filtrage (30) possédant une largeur de bande caractéristique unique représentative de la fréquence bloquée de la boucle.

4. Circuit selon la revendication 1, 2 ou 3, selon lequel le second circuit (64) comprend une résistance ($R_{gain}$) possédant une valeur apte, dans le cas de la présence d'un signal d'erreur, à régler le gain de l'oscillateur VCO, et un circuit formant miroir de courant (Q3, Q4) accouplé à ladite résistance ($R_{gain}$).

5. Circuit selon la revendication 4, dans lequel le signal d'erreur est appliqué à la résistance ($R_{gain}$).

6. Circuit selon la revendication 1, 2 ou 3, dans lequel le second circuit (64) comporte une source de courant ($I_{in}$) apte, en l'absence d'un signal d'erreur, à régler le gain de l'oscillateur VCO, et un circuit formant miroir de courant (Q3, Q4) accouplé à ladite source de courant.

7. Circuit selon la revendication 4, 5 ou 6, dans lequel le circuit formant miroir le courant comporte deux transistors PNP (Q3, Q4) dont les bases sont raccordées l'une à l'autre, l'un desdits transistors (Q3) étant raccordés de manière à posséder des caractéristiques de fonctionnement sensiblement équivalentes à celles d'une diode.

8. Circuit selon l'une quelconque des revendications 1 à 7, dans lequel le premier circuit (56) comporte une source de tension d'alimentation ($V_{cc}$), un circuit formant miroir de courant (Q1, Q2) accouplé à ladite source de tension, et une résistance ($R_{fr}$) accouplée audit circuit formant miroir de courant.

9. Circuit en forme de boucle à verrouillage de phase selon la revendication 8, dans lequel la résistance ($R_{fr}$) peut fonctionner de manière à régler la fréquence de fonctionnement libre ($F_{fr}$) de l'oscillateur VCO.

10. Circuit en forme de boucle à verrouillage de phase selon la revendication 8 ou 9, comportant en outre des moyens résistifs (R1, R2) raccordant le miroir de courant à la source de tension d'alimentation.

11. Circuit en forme de boucle à verrouillage de phase selon l'une quelconque des revendications 1 à 7 dans lequep le premier circuit (56) comporte une source de tension d'alimentation ($V_{cc}$), une source de courant ($I_{fr}$) pouvant fonctionner de manière à régler la fréquence de fonctionnement libre de l'oscillateur VCO et un miroir de courant (Q1, Q2) pouvant fonctionner de manière à accoupler la source de courant à la source d'alimentation en tension.

12. Circuit selon l'une quelconque des revendications 1 à 11, caractérisé en outre en ce que l'oscillateur (38) et le circuit comparateur (28) sont intégrés sur une microplaquette à semiconducteurs ou sur un substrat semiconducteur et que les premier et second circuits (56, 64) comportant des éléments (Q1, 2, 3, 4; R1, R2) sont formés sur la microplaquette ou sur le substrat et que les autres éléments ($R_{gain}$, $R_{fr}$) sont formés en-dehors de la microplaquette ou du substrat.

FIG 1  PRIOR ART

FIG 2

1

FIG 3